**Europäisches Patentamt**

**European Patent Office**

**Office européen des brevets**

(19)

(11) Numéro de publication : **0 466 532 A1**

## (12) DEMANDE DE BREVET EUROPEEN

(21) Numéro de dépôt : **91401590.4**

(51) Int. Cl.⁵ : **G11C 5/14**, G11C 16/06

(22) Date de dépôt : **14.06.91**

(30) Priorité : **21.06.90 FR 9007791**

(43) Date de publication de la demande :
**15.01.92 Bulletin 92/03**

(84) Etats contractants désignés :
**DE FR GB IT**

(71) Demandeur : **SGS-THOMSON
MICROELECTRONICS S.A.
7, Avenue Galliéni
F-94250 Gentilly (FR)**

(72) Inventeur : **Devin, Jean, c/o Cabinet
BALLOT-SCHMIT
7,rue Le Sueur
F-75116 Paris (FR)**

(74) Mandataire : **Schmit, Christian Norbert Marie
et al
Cabinet Ballot-Schmit 7, rue Le Sueur
F-75116 Paris (FR)**

(54) **Dispositif à pompes de charges à phases imbriquées.**

㉟   Pour générer une haute tension dans un circuit de faible impédance, on utilise deux pompes de charges Schenkel à phases imbriquées, une pompe se déchargeant pendant que l'autre se recharge, ce qui permet au dispositif de génération de haute tension ainsi constitué, de délivrer un fort courant, sans que la tension de sortie du dispositif ne chute.

EP 0 466 532 A1

FIG_3

L'invention a pour objet la génération d'une haute tension à partir de la tension d'alimentation Vcc et d'un dispositif à pompes de charges, cette haute tension ayant un niveau stable au cours du temps, indépendamment de l'impédance d'entrée du circuit qu'elle alimente.

D'une manière générale, un tel dispositif sera utilisé avec des circuits dont l'impédance d'entrée est faible devant l'impédance équivalente de la pompe de charge, c'est à dire, avec des circuits qui vont absorber beaucoup de courant.

En particulier, un tel dispositif s'applique au domaine des mémoires non volatiles reprogrammables électriquement, comme les EPROM, les EEPROM ou encore les flash EPROM. De telles mémoires nécessitent pour leur programmation, et dans une moindre mesure pour leur effacement (EEPROM, flash EPROM), non seulement une haute tension Vpp, mais aussi un fort courant. Par exemple, pour la programmation d'une cellule flash EPROM. Il faut fournir une tension de drain de 6 volts et plus pour avoir une programmation dans un temps acceptable (une dizaine de millisecondes au maximum) et une tension de grille de l'ordre de 12 volts. Et le courant demandé par le drain est important (de l'ordre du milliampère).

Auparavant, la haute tension était généralement fournie sur un plot externe de la mémoire, avec en général, un limiteur interne de cette tension, pour se protéger des fluctuations éventuelles et un dispositif interne de protection contre les décharges électrostatiques.

Plus récemment, on a cherché à rendre les circuits intégrés les plus autonomes possibles, notamment les mémoires. On a alors utilisé des multiplieurs de tension, appelés encore pompes de charge, pour fournir la haute tension à partir de l'alimentation disponible: Vcc, Vss. Par exemple, on a utilisé un générateur de type Schenkel bien connu, avec un arrangement de diodes et de capacités dont les bornes sont commutées au rythme de deux horloges de même fréquence, déphasées, H1 et H2.

Mais toute pompe débitant sur une charge voit sa tension de sortie chuter et atteindre une valeur d'équilibre dépendant du courant demandé. Et cette tension limite est d'autant plus faible que le courant requis est important.

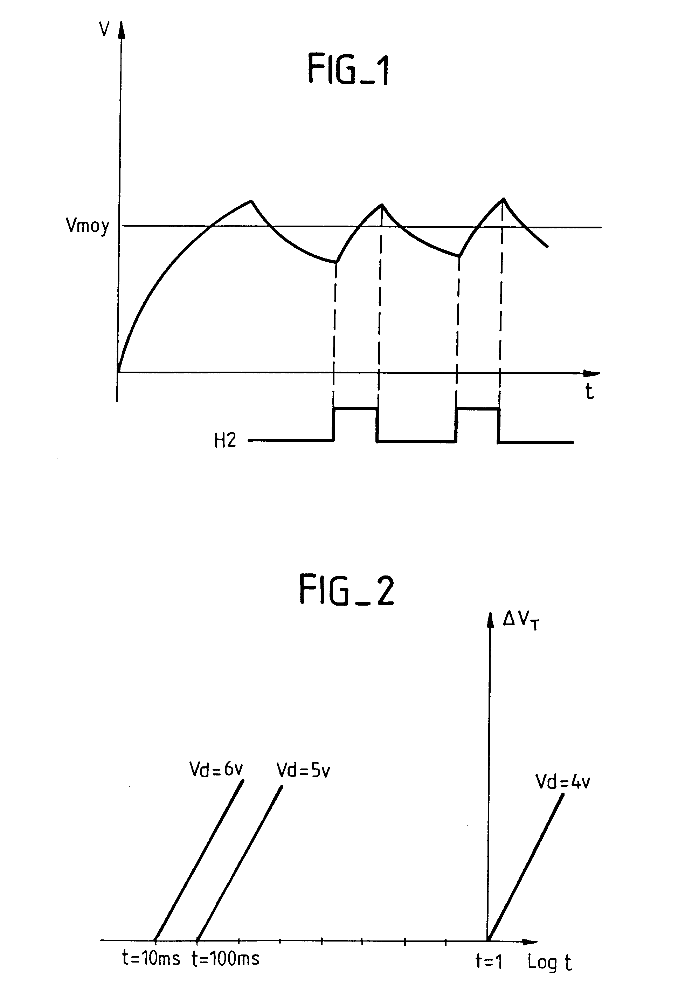

Une pompe est ainsi capable de débiter, pour une chute de tension donnée, un courant de forte valeur, mais seulement pendant un temps relativement réduit, imposé par le fait que la tension ne doit pas descendre en dessous d'une certaine valeur, c'est à dire par le fait que celle-ci ne doit pas trop s'écarter d'une valeur moyenne. Ainsi, dans le cas d'un générateur Schenkel, les horloges H1 et H2 sont par exemple telles que la décharge de la pompe qui se fait sur H1 et la recharge de la pompe qui se fait sur H2, permettent de délivrer un courant donné pour une fluctuation de la tension de sortie acceptable. La courbe de fluctuation de la tension de sortie en fonction du temps est montrée en figure 1.

En pratique, de tels multiplieurs de tension de type Schenkel ne sont utilisés que pour des applications à faible courant : quelques microampères.

Pour des applications nécessitant quelques milliampères, la fluctuation de la tension de sortie est trop gênante, et de tels multiplieurs internes ne peuvent être utilisés. Il faut alors avoir recours à une alimentation externe au circuit.

Si on prend l'exemple de la programmation des mémoires flash EPROM, la fluctuation de la tension de programmation appliquée au drain de la cellule qui absorbe beaucoup de courant, réduit considérablement l'efficacité de programmation. Comme le montre la figure 2, si la tension de drain diminue de quelques volts, il faut attendre beaucoup plus de temps pour que la programmation soit effectuée : variation logarithmique du temps de programmation t avec la tension de drain. Par exemple, si la tension de drain vaut 6 volts, le temps de programmation d'une cellule vaut 10ms, à 5 volts il vaut 10 fois plus.

Une solution pourrait être d'augmenter la fréquence de commutation des horloges : la pompe Schenkel aurait moins de temps pour se décharger et donc la tension de sortie fluctuerait moins. Mais on est limité en pratique par la technologie et avec les fréquences possibles utilisées, par exemple 30 MHZ, ce qui est une limite supérieure pour les technologies actuelles, on ne résout pas le problème.

Une autre solution consisterait à utiliser dans la pompe Schenkel des capacités de valeur 2 fois plus élevées ; l'impédance interne équivalente est alors diminuée de moitié, tandis que le courant que peut délivrer la pompe est multiplié par 2. Mais là aussi la technologie ne permet pas d'utiliser des capacités ayant des valeurs trop fortes.

Dans l'invention, on propose d'utiliser deux pompes de charges en parallèle et à phases imbriquées. Le temps pendant lequel une pompe débite est alors mis à profit par l'autre pompe pour se recharger : ainsi, la tension de sortie fluctue beaucoup moins.

L'invention a donc pour objet un dispositif de génération de haute tension comportant une première pompe de charges Schenkel à n étages avec une diode de sortie et deux horloges de commutation de même fréquence et non recouvrantes, une première horloge commandant les étages impairs et une seconde horloge commandant les étages pairs, et une deuxième pompe de charges Schenkel avec une diode de sortie, caractérisé en ce que la deuxième pompe de charges est à n étages et qu'elle est montée en parallèle à la première pompe de charges sur une même capacité de sortie du dispositif, les cathodes des diodes de sortie étant reliées à une même borne de la capacité de sortie, l'autre borne étant reliée à la masse, la première horloge de commutation commandant les étages pairs de la deuxième pompe de charges et la deuxième horloge de commutation commandant les étages impairs de la deuxième pompe de charges.

D'autres avantages et caractéristiques de l'invention sont donnés dans la description qui suit, faite à titre indicatif et nullement limitatif de l'invention et en référence aux figures annexées, dans lesquelles :

 – La figure 1 est un diagramme de charge et de décharge d'une pompe de charge, déjà décrite,
 – La figure 2 est un diagramme de temps de programmation en fonction de la tension de drain d'une cellule flash EPROM, déjà décrite,
 – La figure 3 est un schéma électrique d'un dispositif à pompes de charges à phases imbriquées, selon l'invention,
 – La figure 4 est un diagramme de charge et de décharge d'un dispositif de la figure 3.

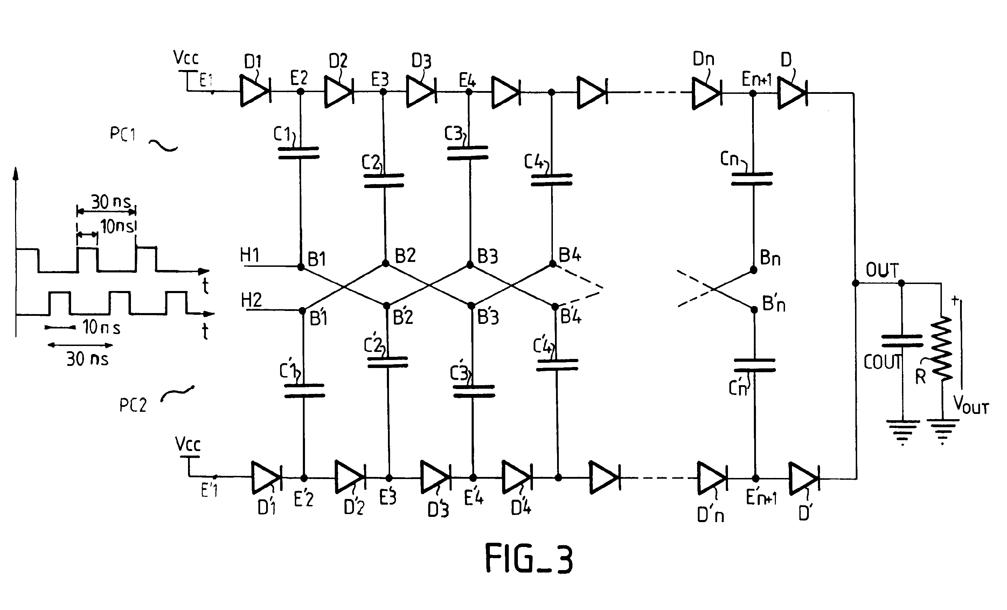

La figure 3 est un schéma électrique d'un dispositif de pompes de charges selon l'invention. Dans cet exemple, on utilise deux pompes de charges PC1 et PC2 en parallèle entre Vcc et un noeud de sortie OUT.

La pompe de charge PC1 comporte n étages, chaque étage i comportant une diode Di et une capacité Ci ($i \in \{1, n\}$).

La diode Di a son anode au noeud E(i) et sa cathode au noeud E(i+1). La capacité Ci est placée entre le noeud E(i+1) et un noeud Bi. Le noeud E(1) du premier étage est connecté à la tension d'alimentation Vcc. Le noeud E(n+1) du n-ième étage est connecté à l'anode d'une diode D. La cathode de la diode D est connectée au noeud de sortie OUT du dispositif. Sur la sortie OUT du dispositif, une borne d'une capacité COUT est connectée, l'autre borne de la capacité étant reliée à la masse : c'est la capacité de sortie du dispositif. La diode D et la capacité COUT forment l'étage de sortie de la pompe PC1.

Tous les étages (Ci, Di) de rang impair (1,3,...) sont commandés par le signal d'horloge H1 : tous les noeuds Bi de rang impair reçoivent le signal d'horloge H1.

Tous les étages (Ci, Di) de rang pair (2,4,...) sont commandés par le signal d'horloge H2 : tous les noeuds Bi de rang pair reçoivent le signal d'horloge H2. Dans l'exemple, n est pair et Bn reçoit le signal d'horloge H2 : la charge de l'étage de sortie de la pompe se fait donc sur H2.

Les horloges H1 et H2 sont non recouvrantes et de même fréquence. Par exemple, la fréquence est de 30 MHZ et la durée de l'impulsion de 10 ns pour H1 et H2.

La pompe de charge PC2 comporte elle aussi dans l'exemple n étages, chaque étage i comportant une diode D'i et une capacité C'i. La diode D'i a son anode au noeud E'i et sa cathode au noeud E'(i+1). La capacité C'i est placée entre le noeud E'(i+1) et un noeud B'i. Le noeud E'1 du premier étage est connecté à la tension d'alimentation Vcc. Le noeud E'(n+1) est connecté à l'anode d'une diode D'. La cathode de la diode D' est connectée au noeud de sortie OUT du dispositif. Sur la sortie OUT du dispositif, une borne d'une capacité COUT est connectée, l'autre borne de la capacité étant reliée à la masse : c'est la capacité de sortie du dispositif. La diode D' et la capacité COUT forment l'étage de sortie de la pompe PC2.

Le nombre d'étages de la pompe PC2 pourrait être n' différent de n. Mais en prenant des pompes identiques PC1 et PC2, on obtient une symétrie qui rend plus simple la réalisation du dispositif.

Pour la pompe de charge PC2 décrite, de schéma identique à la pompe PC1, on a inversé, dans l'invention, le rôle des horloges H1 et H2, de manière à ce que la charge de l'étage de sortie de chaque pompe se fasse sur une horloge différente : dans l'exemple, la charge de l'étage de sortie se fait sur H2 pour la première pompe et sur H1 pour la seconde. Ainsi, dans l'exemple pris où le nombre d'étage est le même pour les 2 pompes et où n est pair, ce sont les étages (C'i, D'i) de rang pair qui sont commandés par le signal d'horloge H1 et ceux de rang impair qui sont commandés par le signal d'horloge H2. Ainsi, les noeuds B'i de rang pair reçoivent le signal d'horloge H1. Les noeuds B'i de rang impair reçoivent le signal d'horloge H2.

Dans l'exemple, n a été pris pair. Ainsi, le noeud B'n reçoit le signal d'horloge H1 et l'étage de sortie (D', COUT) de la deuxième pompe se charge sur H1.

La sortie OUT du dispositif est par ailleurs connectée à l'entrée d'un circuit qui peut-être représenté par son impédance d'entrée, R dans l'exemple, entre le noeud OUT et la masse.

Dans ces conditions, les étages (Ci, Di) impairs de la pompe PC1 vont se charger H1 est à 0 volts et H2 à 5 volts, tandis que les étages pairs se déchargent. Les étages pairs vont eux se charger quand H1 est à 5 volts et H2 à 0 volts, tandis que les étages impairs se déchargent. Ainsi la capacité COUT, qui avec la diode D constitue l'étage de sortie de la pompe, n étant pair dans l'exemple, va se charger quand H2 est à 5 volts et se décharger quand H2 est à 0 volts : la charge de l'étage de sortie (D,COUT) se fait sur H2.

La pompe PC2 va donc avoir le fonctionnement complémentaire, puisque le rôle des horloges H1 et H2 a été inversé par rapport à la pompe PC1 : les étages (C'i, D'i) pairs se chargent et les étages impairs se déchargent pour H2 égal à 0 volts et H1 égal à 5 volts; les étages impairs se chargent et les étages pairs se déchargent pour H2 égal à 5 volts et H1 égal à 0 volts. Et la capacité de sortie COUT, qui avec la diode D' constitue l'étage de sortie de la deuxième pompe, n étant pair dans l'exemple, va se charger quand H1 est à 5 volts et se décharger quand H1 est à 0 volts.

Ainsi, pendant que la sortie d'une pompe se décharge, l'autre se charge, les horloges H1 et H2 étant non recouvrantes : globalement, la tension de sortie VOUT du dispositif ne fluctue pas.

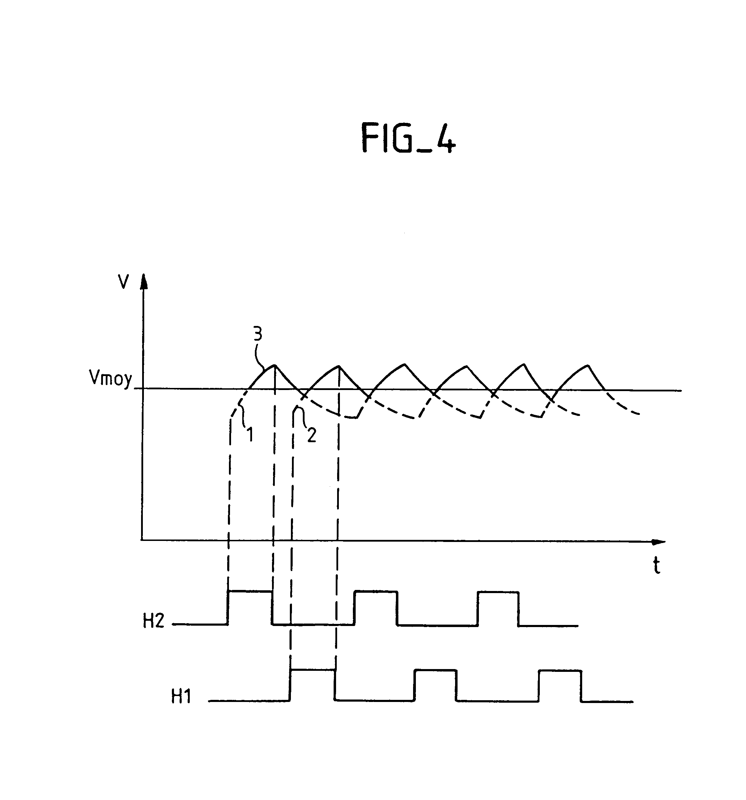

C'est ce qui est montré sur la figure 4 : sur ce diagramme de la variation de la tension de sortie VOUT en fonction du temps, la courbe 1 correspond au fonctionnement de la pompe PC1 et la courbe 2 correspond au fonctionnement de la pompe PC2. Ces deux courbes sont identiques et sont constituées par une succession de portions de courbes de charges et de décharges. Elles sont décalées, le décalage correspondant au décalage temporel des deux horloges H1 et H2. La résultante ou l'enveloppe de ces 2 courbes donne la courbe 3 du dispositif de l'invention: la tension de sortie VOUT varie beaucoup moins autour d'une valeur moyenne, l'alternance de fonctionnement des deux pompes de charge empêchant le dispositif de trop se décharger.

Ainsi, il est possible d'utiliser un générateur de haute tension interne dans un circuit intégré, même pour des applications à fort courant.

## Revendications

1. Dispositif de génération de haute tension comportant une première pompe de charges Schenkel (PC1) à n étages (Ci, Di) avec une diode de sortie (D) et deux horloges de commutation de même fréquence et non recouvrantes, une première horloge (H1) commandant les étages (Ci, Di) impairs et une seconde horloge (H2) commandant les étages (Ci, Di) pairs, et une deuxième pompe de charges Schenkel (PC2) avec une diode de sortie (D'), caractérisé en ce que la deuxième pompe de charges est à n étages (C'i, D'i) et qu'elle est montée en parallèle à la première pompe de charges (PC1) sur une même capacité de sortie (COUT) du dispositif, les cathodes des diodes de sortie (D) et (D') étant reliées à une même borne de la capacité de sortie (COUT), l'autre borne étant reliée à la masse, la première horloge de commutation (H1) commandant les étages pairs de la deuxième pompe de charges (PC2) et la deuxième horloge de commutation (H2) commandant les étages impairs de la deuxième pompe de charges (PC2).

# FIG_1

V

Vmoy

H2

t

# FIG_2

$\Delta V_T$

Vd=6v   Vd=5v

Vd=4v

t=10ms   t=100ms

t=1   Log t

6

FIG_3

EP 0 466 532 A1

# FIG_4

Office européen
des brevets

## RAPPORT DE RECHERCHE EUROPEENNE

Numero de la demande

EP    91 40 1590

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | WO-A-8 606 205 (EUROTECHNIQUE) <br> * page 6, ligne 18 - page 7, ligne 15 * <br> --- | 1 | G11C5/14 <br> G11C16/06 |
| A | EP-A-0 349 495 (SGS THOMSON) <br> * colonne 1, ligne 1 - colonne 6, ligne 40; figures 1,3 * <br><br> ----- | 1 | |

DOMAINES TECHNIQUES
RECHERCHES (Int. Cl.5)

G11C
G05F

Le présent rapport a été établi pour toutes les revendications

| Lieu de la recherche | Date d'achèvement de la recherche | Examinateur |
|---|---|---|
| LA HAYE | 08 NOVEMBRE 1991 | STECCHINA A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)